Europäisches Patentamt

European Patent Office

Office européen des brevets

(19)

(11) Publication number: **0 112 662**
**A1**

## EUROPEAN PATENT APPLICATION

(12)

(21) Application number: **83307265.5**

(22) Date of filing: **29.11.83**

(51) Int. Cl.³: **H 01 L 27/04, H 01 L 23/48**

(30) Priority: **21.12.82 US 451771**

(43) Date of publication of application: **04.07.84**
**Bulletin 84/27**

(84) Designated Contracting States: **AT CH DE FR GB LI NL SE**

(71) Applicant: **NORTHERN TELECOM LIMITED,**
**1600 Dorchester Boulevard West, Montreal Quebec**
**H3H 1R1 (CA)**

(72) Inventor: **Naem, Abdalla Aly, 201 Bell Street, North 916A,,**
**Ottawa Ontario (CA)**
Inventor: **Calder, Iain Douglas, 27 Cleadon Road, Kanata**
**Ontario (CA)**
Inventor: **Boothroyd, Albert Roy, 13 Erinlea Court,**
**Nepean Ontario (CA)**

(74) Representative: **Crawford, Andrew Birkby et al, A.A.**
**THORNTON & CO. Northumberland House 303-306 High**
**Holborn, London WC1V 7LE (GB)**

(54) **Stacked MOS devices with polysilicon interconnects.**

(57) A stacked metal-oxide-semiconductor (MOS) device has a lower source (18), drain (20) and channel (34) formed in a silicon substrate (12) and an upper source (30), drain (32) and channel (36) formed in a deposited polysilicon layer (28) which is recrystallized by laser annealing. Instead of the conventional method of depositing aluminum interconnects between the device upper terminals and bonding pads, interconnect parts (29) are formed in the recrystallized polysilicon layer (28) itself. This has the advantages of preventing junction distortion by undesired aluminum penetration into the silicon. Also contact windows do not have to be opened directly to the source and drain terminals thereby easing desing constraints.

1

This invention relates to stacked metal-oxide-semiconductor (MOS) devices and to a method for making them.

In the design of new very large scale integrated (VLSI) circuits, attempts have been made to reduce the device area by scaling the structural and electrical parameters in proportion. However, there are limitations imposed by this approach on device performance and fabrication as described by Hoeneisen and Mead, Solid State Electronics, Volume 15, pages 819 to 829, 1972.

Recently vertical integration of devices has been proposed as an alternative to scaling down device area to achieve higher packing density. Stacked CMOS inverters having a common gate for both n- and p-channel transistors have been described by Gibbons et al, IEEE Electron Device Letters, EDL-1, page 11 et seq, and by Geoloe et al, IEDM, Washington, D.C. page 544 et seq, 1981. A stacked CMOS inverter more conducive to standard silicon integrated circuit fabrication techniques has been suggested by Colinge et al, IEEE Electron Device Letters, EDL-2, pages 250 et seq, 1981. The n- and p-type transistors making up the inverter are stacked one on top of the other and have a common gate, a common drain and isolated sources. The top part of the common drain is laser annealed polysilicon which is essentially integral with a bottom part of the drain formed within the silicon substrate.

In the Colinge et al device, an aluminum interconnect extends through a via within a $SiO_2$ coating overlying the common drain to connect the drain to a laterally offset bonding pad. One of the disadvantages of this structure, especially if device performance is optimized by having a very shallow drain region in the substrate, is that during the contact sintering operation, or other higher temperature

2

operations subsequent to metallization, spikes or spears of aluminum metal penetrate vertically or laterally into the silicon surrounding the contact windows. This can result in junction degradation or even shorting. A further disadvantage is that the drain region must be made somewhat larger than necessary for device operation simply to ensure that the interconnect via formed through the $SiO_2$ layer will lie over the drain.

A stacked metal-oxide-semiconductor device is now proposed which eliminates the contact windows and aluminum interconnects.

According to one aspect of the invention there is provided a stacked metal-oxide-semiconductor device having a first channel, source and drain within a silicon substrate, and a second channel, source and drain within a selectively recrystallized polysilicon layer formed above the substrate, said polysilicon layer having an additional recrystallized interconnect part extending from at least one of the upper source and drain to a laterally offset bonding pad.

The stacked metal-oxide-semiconductor device can be a transistor in which the first and second sources are integral with one another, the first and second drains are integral with one another, and the channels are spaced from one another by a common gate formed within gate oxide. Alternatively, the MOS structure is a pair of transistors, for example, in a CMOS inverter arrangement, in which the first and second sources are integral with one another and the first and second drains are isolated from one another or a similar structure in which the drains are integral and the sources are isolated.

In a preferred form of the device, a gate or gates controlling the channels also consist of recrystallized polysilicon. In effect, the recrystallized polysilicon in which the upper source, channel and drain are located functions as a second silicon substrate. To achieve further vertical integration appropriate oxide and polysilicon layers can be grown or deposited to form a transistor or transistors which have several possible channels or channel routes between them. Preferably the crystal orientation of the upper source, drain and channel is such as to form an essentially epitaxial continuation of the underlying source and drain within the substrate. By adopting a stacking technique, the channel area occupied by a device or devices is vertically distributed so that the effective device area is reduced. Device performance is improved when the channel regions are made narrower as well as short as described by Naem et al in Electronics Letters, pages 135 to 136, February 1982.

The polysilicon in the upper source, drain and interconnect parts is rendered highly conductive by laser annealing and doping.

According to another aspect of the invention there is provided in a method of fabricating a stacked metal-oxide-semiconductor structure the steps of forming a first source region, a first drain region and a first channel region in a silicon substrate, forming a gate within an oxide layer overlying a first channel region extending between the source and drain regions, subsequently forming thereon a recrystallized polysilicon layer, and forming in the recrystallized polysilicon layer a second source region, a second drain region, a second channel region and an interconnect region extending away from at least one of said second source and drain regions to a bonding pad.

Said at least one of the second source and drain regions can be made integral with an underlying corresponding one of the first source and drain regions.

4

By extending the recrystallized polysilicon from the upper source and drain regions to the sites of bonding pads, the need for contact windows to be opened immediately above the common source and drain is eliminated so providing an additional degree of freedom to the device designer. Moreover as previously indicated, by keeping the aluminum away from the source or drain junction the risk of aluminum penetration into the junction is eliminated.

The method preferably includes the following additional steps. The second source and drain regions, a second channel region extending between the second source and drain regions and the or each interconnect region are formed by laser annealing and appropriately doping the polysilicon layer. The polysilicon is deposited by low pressure chemical vapour deposition over the complete wafer and then selectively etched following doping and laser annealing.

The polysilicon layer is doped by ion implantation to provide an active top layer substrate and is recrystallized by laser annealing after deposition of an anti-reflective nitride coating on the polysilicon layer to cover the source, drain, top channel region and interconnects to the sites of bonding pads. Because that part of the polysilicon layer overlying the gate is thermally insulated from the substrate by gate oxide, then during laser annealing it is rendered hotter than the polysilicon overlying the substrate drain and source regions from which heat can more easily dissipate to the substrate. Thus on cooling, it solidifies later than the polysilicon around it and consequently seeded crystal conversion occurs first adjacent the substrate drain and source regions and later at the polysilicon over the gate. In effect, the substrate crystal orientation spreads throughout the recrystallized polysilicon within the top device active area. Subsequently, using standard etching and photolithographic techniques, the nitride coating is removed and the second source and drain regions are formed for example by dopant pre-deposition and drive-in. Bonding pads are made by depositing a pyroglass layer over the wafer, opening windows through the pyroglass layer at appropriate sites, and depositing aluminum through the windows onto the distal ends of the interconnects and onto an extension of the common gate projecting out of the channel region. The aluminum deposits provide bonding pads for applying voltages to the device terminals.

The gate which is prepared in an intermediate part of the process can also be prepared by laser annealing and doping a deposited polysilicon layer. The gate oxide is thermally grown in a two stage process, the first layer being grown on the substrate before deposition and formation of gate polysilicon and the second layer being grown on the gate following polysilicon deposition, doping, laser annealing and etching to define the gate. The gate is grown with a lateral projection extending out of the channel region to which a bonding pad can be electrically connected.

An embodiment of the invention will now be described by way of example with reference to the accompanying drawings in which:-

Figure 1 is a sectional view showing a stacked metal-oxide-semiconductor (SMOS) transistor;

Figures 2a to 2h show successive stages in the preparation of the Figure 1 transistor using a fabrication technique according to the invention;

Figure 3 is a schematic plan view of the superimposed areas of masks used in the fabrication of the Figure 1 transistor; and

Figure 4 is a sectional view showing a stacked CMOS inverter according to the invention.

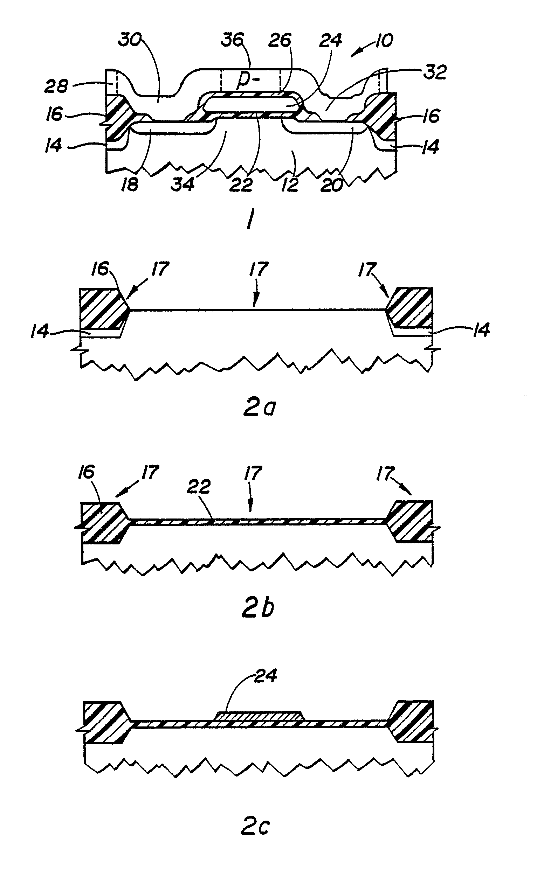

Referring to Figure 1, an SMOS transistor 10 has a p-type silicon substrate 12. $P^+$-type regions 14 underlie $SiO_2$ field oxide regions 16 which provide isolation from adjacent transistors (not shown). Within the substrate are $n^+$-type source and drain regions 18 and 20 respectively. Extending between the source and drain regions and overlying the substrate is a first gate oxide layer 22. Over the gate oxide layer is a recrystallized polysilicon gate 24 and a second gate oxide layer 26. Overlying the whole structure is a recrystallized polysilicon layer 28 which is doped to give source and drain regions 30 and 32 respectively contacting the source and drain regions 18 and 20 in the silicon substrate. Between the source and drain regions at respective levels are $p^-$-type channel regions 34 and 36.

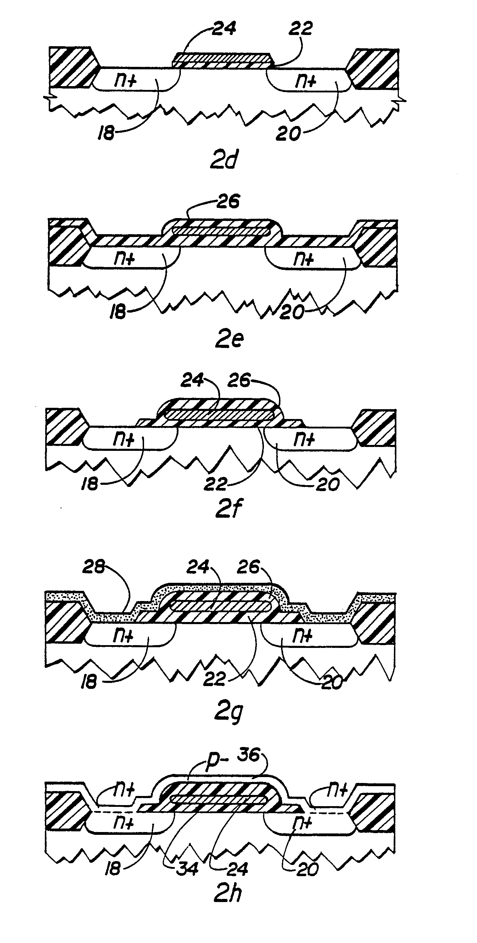

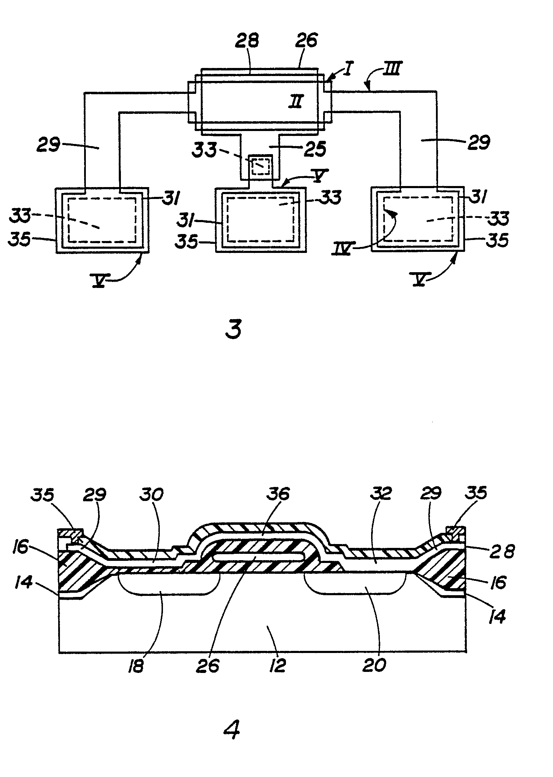

Referring to Figure 3 the recrystallized polysilicon layer 28 has interconnect regions 29 which connect the source and drain regions 30 and 32 to bonding pads 35. A central bonding pad is connected to a lateral extension of the gate 26.

The Figure 1 device is a stacked n-channel enhancement mode transistor. In operation, a voltage applied to the common gate 26 induces an electric field within channel regions 34 and 36. When the gate voltage is of proper polarity and magnitude a localized inversion layer is formed both above and below the gate to render the upper and lower channel regions conducting. Conduction takes place between sources and drains, the current depending on the gate voltage and the source to drain voltage. In effect the channel duty of the transistor is vertically shared between two channels. The Figure 1 transistor has two spaced channel regions 34

7

and 36 but there is no reason why, in principle, the transistors should not have more than two vertically spaced channels if further vertical integration is desired.

Having specifically described the Figure 1 structure the preferred method for fabricating it is now described.

Referring to Figure 2a on a p-type silicon substrate, a boron ion-implantation 14 is performed and field oxide 15 is grown using a known LOCOS technique and a first mask defining an area I (Figure 3) to define a device well 17. A first gate oxide layer 22 is then thermally grown (Figure 2b).

Referring to Figure 2c, using a second mask to define an area II (Figure 3) a 7500Å polysilicon layer is low pressure chemically vapour deposited at 625°C and then patterned to produce a common gate region 24 having a lateral projection 25.

Referring to Figure 2d, standard techniques are used to define the gate oxide 22 and at the same time to define the source and drain regions within the substrate. A phosphorus ion implantation technique is used to obtain $n^+$-type doping in the regions 18 and 20. The polysilicon in the gate region is then recrystallized in a laser annealing step using an argon laser with a power output of about 6 watts, a beam diameter of 50 microns, and a scan rate of 50cm/second. The polysilicon structure is changed from small to large grains with a corresponding increase in conductivity. The laser annealing step is also used to drive the implanted phosphorus impurities into the gate, source and drain regions to render them highly conducting.

Referring to Figure 2e a 1000Å layer of top gate oxide is then thermally grown at 1050°C in dry oxygen and, using standard techniques, the gate oxide is selectively etched to expose the $n^+$-type source and drain regions 18 and 20 (Figure 2f).

Referring to Figure 2g, a 7500Å polysilicon layer 28 is low-pressure chemically vapour deposited at 625°C over the entire chip. The polysilicon is implanted with boron at a dosage of $5 \times 10^{11}/cm^2$ at 60Kev to form an active p-type substrate for the upper channel 36 of the Figure 1 transistor. A 600Å layer of silicon nitride is then low-pressure chemically vapour deposited at 650°C and is defined using a third mask defining the area III (Figure 3) so as to cover both the device well which extends between the isolating field oxide region 16, and interconnect regions 29 which extend from the source and drain to the sites 31. This layer functions as an anti-reflective coating during a subsequent selective laser annealing step using an argon laser with the previously cited operating conditions. The nitride layer ensures that the underlying polysilicon is melted during laser annealing. The polysilicon overlying the gate 24 since it is thermally insulated from the substrate by the gate oxide is hotter than that overlying the source and drain regions and consequently cools and crystallizes later. The substrate source and drain regions 18 and 20 therefore function to seed crystal conversion within the polysilicon layer 28, the crystal formation propagating away from the substrate source and drain regions into the channel region 36 overlying the gate 24.

The anti-reflective coating is subsequently removed by etching using the third mask which defines area III (Figure 3). A phosphorus ion implantation technique is then used to render $n^+$-type the regions of the recrystallized polysilicon overlying the substrate source and drain (Figure 2h). In effect, additional source and drain regions 30,

9

32 are formed in the polysilicon 28, these being integral with the source and drain regions 18 and 20 in the substrate.

Referring again to Figure 3, following the deposition of a pyroglass layer over the complete chip, a fourth mask which defines the area IV is used to open contact windows 33 to the polysilicon at the outer bonding pad regions, and to the gate polysilicon at the projection 25. Finally, using a fifth mask which defines an area V, aluminum is chemically vapour deposited onto the outer ends of the polysilicon leads 29 to function as source and drain bonding pads. Simultaneously, aluminum is deposited to bridge the gate extension 25 and the site of a gate bonding pad.

Although the invention has been described in terms of a stacked MOS device functioning as a single transistor, it will be appreciated that the invention can be used to advantage in alternative structures where a layer of polysilicon has been deposited and subsequently recrystallized in order to form an active substrate in which further MOS formations can be produced. Thus in the Colinge et al stacked CMOS inverter described in the introduction and illustrated in Figure 4 and in which features corresponding to the Figure 1 SMOS structure are designated by like numerals, the device has a common drain 20, 32 and isolated sources 18 and 30. Recrystallized polysilicon interconnects 29 are formed by appropriately doping and laser annealing regions of the polysilicon layer 28 so as to electrically connect the common drain and the top source to laterally offset bonding pads 35. Interconnects (not shown) to the lower source 18 and to the gate terminal 26 are conventionally made by aluminum evaporation through appropriately sited windows.

10

In these stacked MOS structures, the polysilicon interconnects 29 are relatively short. In addition the sheet resistivity of polysilicon which is laser annealed and doped to a level of $10^{21}$ carriers/cm$^3$ is 5Ω/□ which is sufficiently low for an interconnect material. Consequently although there is a small increase in terminal resistance, it is more than offset by lowering the risk of the substrate junctions being affected by aluminum penetration into the junctions and by the added degree of freedom afforded to the designer by not having to open windows to the source, drain or both.

11

CLAIMS:

1. A metal-oxide-semiconductor device having a lower channel, source and drain within a silicon substrate and an upper channel, source and drain within a selectively recrystallized polysilicon layer formed above the substrate wherein an interconnect extends from at least one of the upper source and drain to a bonding pad, the bonding pad being laterally offset from said at least one of the second source and drain characterized in that the interconnect (29) is part of the selectively recrystallized polysilicon laer (28).

2. A metal-oxide-semiconductor device as claimed in claim 1 further characterized in that the upper and lower sources (30, 18) are integral with one another.

3. A metal-oxide-semiconductor device as claimed in claim 1 further characterized in that the upper and lower drains (32, 20) are integral with one another.

4. A metal-oxide-semiconductor device as claimed in claim 1 further characterized in that the upper and lower sources (30, 18) are integral with one another and the upper and lower drains (32, 20) are integral with one another.

5. A metal-oxide-semiconductor device as claimed in claim 2 further characterized in that the recrystallized polysilicon layer (28) is a substantially epitaxial continuation of the substrate (12).

12

6. A metal-oxide-semiconductor device as claimed in claim 1 further characterized in that the polysilicon interconnects (29) are formed on top of field oxide (16).

7. A metal-oxide-semiconductor device as claimed in claim 1 further characterized in that a pyroglass layer is formed over the interconnects (29) and a window (33) extends through the pyroglass layer to distal ends of the or each interconnect (29).

8. A metal-oxide-semiconductor device as claimed in claim 7 further characterized in that the distal ends of the interconnects (29) are wider than the average width of the interconnects (29).

9. A metal-oxide-semiconductor device as claimed in claim 7 further characterized in that the bonding pads (35) are made of aluminum which is evaporated through windows (33) in the pyroglass layer.

10. A metal-oxide-semiconductor device as claimed in claim 1 further characterized in that the polysilicon layer (28) is spaced from the substrate (12) by a common gate (24) formed within a layer of gate oxide (22, 26).

11. A metal-oxide-semiconductor device as claimed in claim 10 further characterized in that the gate (24) is formed of recrystallized polysilicon.

13

12. A metal-oxide-semiconductor device as claimed in claim 11 further characterized in that the gate (24) has a natural extension (25) extending out of the device channel region and an aluminum bonding pad (35) electrically contacts the extension (25) through a via in an overlying pyroglass layer.

13. A metal-oxide-semiconductor device as claimed in claim 1 further characterized in that the device is a single transistor.

14. A metal-oxide-semiconductor device as claimed in claim 1 further characterized in that the device is a CMOS inverter.

1

2a

2b

2c

2d

2e

2f

2g

2h

*3*

*4*

European Patent
Office

**EUROPEAN SEARCH REPORT**

Application number

EP 83 30 7265

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | EP-A-0 021 133 (TOKYO SHIBAURA)<br>* Page 9, lines 32-35 *<br><br>--- | 1,6 | H 01 L 27/04<br>H 01 L 23/48 |
| A | IEEE TRANSACTIONS ON ELECTRON DEVICES, vol. ED-29, no. 4, April 1982, New York J.-P. COLINGE et al. "Stacked transistors CMOS (ST-MOS), an NMOS technology modified to CMOS", pages 585-589<br>* Page 586, section III *<br><br>----- | 3,10,<br>11,14 | |
| | | | **TECHNICAL FIELDS SEARCHED (Int. Cl. 3)**<br><br>H 01 L 23/48<br>H 01 L 23/52<br>H 01 L 27/04 |

The present search report has been drawn up for all claims

| Place of search<br>BERLIN | Date of completion of the search<br>24-01-1984 | Examiner<br>GIBBS C.S. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82